# EUROPÄISCHE PATENTSCHRIFT

(11) **EP 0 779 017 B1**
(45) Veröffentlichungstag und Bekanntmachung des Hinweises auf die Patenterteilung: **15.07.1998**
(21) Anmeldenummer: 95926839.2
(22) Anmeldetag: 02.08.1995
(51) Int. Cl.: H05K 7/14

(54) **VORRICHTUNG ZUM EINRÜCKEN EINER STECKBAUGRUPPE IN EINEN BAUGRUPPENTRÄGER**
DEVICE FOR FITTING A PLUG-IN UNIT INTO A SUPPORT
DISPOSITIF PERMETTANT D'ENFONCER UN BLOC ENFICHABLE DANS UN SUPPORT APPROPRIE

(30) Priorität: 31.08.1994 DE 9414105 U
(43) Veröffentlichungstag der Anmeldung: 18.06.1997
(73) Patentinhaber: Siemens Nixdorf Informationssysteme AG, 33106 Paderborn (DE)
(72) Erfinder: KNOOP, Franz-Josef, D-33142 Büren (DE)
(74) Vertreter: Epping, Wilhelm, Dr.-Ing.
(86) Internationale Anmeldenummer: DE9501008
(87) Internationale Veröffentlichungsnummer: WO9607303

(56) Entgegenhaltungen:
- EP-A- 0 398 030
- US-A- 2 855 454
- PATENT ABSTRACTS OF JAPAN vol. 18 no. 560 (E-1621) ,26.Oktober 1994 & JP,A,06 204670 (MITSUBISHI ELECTRIC CORP) 22.Juli 1994,

## Beschreibung

Die Erfindung betrifft eine Vorrichtung zum Einrücken einer Steckbaugruppe in einen Baugruppenträger nach dem Oberbegriff des Anspruchs 1.

Bei elektronischen Anlagen insbesondere der Daten- und Nachrichtentechnik muß die Möglichkeit bestehen, einzelne Elektronikbaugruppen, die im allgemeinen als in einem Baugruppenträger gehaltene Steckbaugruppen ausgebildet sind, auszutauschen oder hinzuzufügen. Dazu ist es erforderlich, laufende Programme vorschriftsmäßig zu beenden und die Daten zu sichern. Nach dem Einschalten ist dann ein neuer Systemstart erforderlich. Dadurch ergeben sich lange Zeiten, in denen die Anlage nicht zur Verfügung steht, obwohl der eigentliche Austausch bzw. die Nachrüstung einer Steckbaugruppe nur wenige Augenblicke dauert.

Es ist daher die Aufgabe der Erfindung, eine Vorrichtung der eingangs genannten Art zu schaffen, mit der ein Austausch oder das Hinzufügen einer Steckbaugruppe möglich ist, ohne die elektronische Anlage abschalten zu müssen.

Die Aufgabe wird durch die kennzeichnenden Merkmale des Anspruchs 1 gelöst.

Aus der US-A-2 855 454 ist bereits eine Vorrichtung der genannten Art bekannt. Darin ist das eine Gewindeelement an einem Einschub als Hülse mit einer in deren Umfang eingelassenen Nut ausgebildet, die an ihrem in Richtung des anderen Gewindeelements weisenden Ende offen ist, achsparallel zu der Hülse beginnt und dann in einen um die Hülse gewundenen Bereich übergeht. Das andere Gewindeelement wird durch ein Loch in einer Gehäuserückwand gebildet, in welches ein Zapfen radial hineinragt. Die Hülse ist mittels einer Handhabe um ihre Längsachse drehbar.

Zum Einschieben der Steckbaugruppe in den Baugruppenträger muß die Nut zunächst mit dem Zapfen in Flucht gebracht werden. Darauf kann die Steckbaugruppe weiter eingeschoben werden, bis der Zapfen in den gewundenen Bereich der Nut gelangt. Erst jetzt ist es möglich, die Steckbaugruppe durch manuelles Drehen der Hülse in den Baugruppenträger einzurücken.

Die Erfindung geht von der Überlegung aus, daß bei dem bisher üblichen Austauschen oder Einstecken von Steckbaugruppen von Hand eine nicht vorherbestimmbare Zeit verbraucht wird. Würde man diese Handlungen bei laufender Anlage vornehmen, so wäre die Konfiguration der Anlage für unbestimmte Zeit verändert, und ein Zugriff des Anlagenrechners auf eine gerade herausgezogene Steckbaugruppe würde zu Ablauffehlern des Betriebssystems führen.

Die erfindungsgemäße Vorrichtung ermöglicht es, Steckbaugruppen innerhalb einer vorgegebenen Zeitspanne zu wechseln, indem die einzusteckende Baugruppe so weit in den Baugruppenträger eingesteckt wird, daß die Gewindespindel unmittelbar vor dem Eingriff in die Gewindemutter steht. Dabei ist die elektrische Steckverbindung zwischen der Baugruppe und dem Baugruppenträger noch nicht hergestellt. Wird der Motor nun in Einzugsrichtung bestromt, wird die Steckbaugruppe durch das Zusammenwirken der Gewindeelemente in einer von der Handlung des Menschen unabhängigen Zeit in den Baugruppenträger eingerückt.

Um die Koppelung zwischen den Gewindeelementen und damit die Transportverbindung besonders zuverlässig zu gestalten, ist das Gewinde wenigstens eines Gewindeelements so gestaltet, daß die Gewinde beider um wenigstens einen Gewindegang ineinander greifen, ohne den Motor zu betätigen. Dies geschieht durch Einschieben der Steckbaugruppe in den Baugruppenträger. Die Gewindeelemente werden dabei zusammengedrückt und verrasten miteinander. Der Motor kann nun betätigt werden, ohne daß es zum Rutschen zwischen beiden Gewindeelementen oder zu einem Schiefeinzug kommt.

Zum Auswechseln von Steckbaugruppen wird die einzurückende Steckbaugruppe in einen Reserveeinschubplatz des Baugruppenträgers wie vorbeschrieben eingeschoben. Zunächst wird darauf der der auszudrückenden Baugruppe zugeordnete Motor in Auswurfrichtung angetrieben. Sowie die elektrische Verbindung zu dieser Baugruppe unterbrochen ist, wird der Motor des Reserveplatzes in Einzugsrichtung bestromt. Der Zeitraum, in dem keine der Baugruppen mit dem Baugruppenträger elektrisch verbunden ist, kann mithin im Millisekunden-Bereich gehalten werden.

Bei einer Weiterbildung der Erfindung sind die Motoren durch die Anlage selbst steuerbar, zu der der Baugruppenträger gehört. Dadurch kann der Anlagenrechner - ggf. unter Steuerung eines Hilfsprogramms - den Zeitpunkt des Baugruppenwechsels selbst bestimmen und während dieser Zeit das Ansprechen der betroffenen Baugruppen unterbinden.

Weitere Merkmale und Vorteile der Erfindung sind den Ansprüchen, der Beschreibung und der Zeichnung eines Ausführungsbeispiels zu entnehmen. Die Zeichnung zeigt in
- Fig 1: Teile eines Baugruppenträgers und eine Einschubbaugruppe mit der erfindungsgemäßen Vorrichtung in perspektivischer Darstellung,
- Fig 2: eine teilweise geschnittene Seitenansicht der Gewindeelemente.

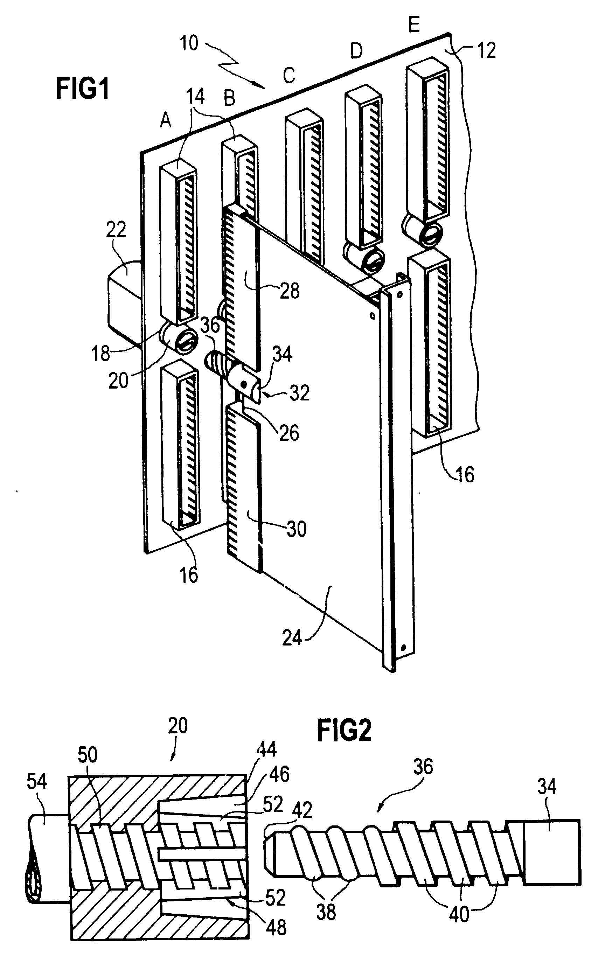

In Figur 1 ist von einem Baugruppenträger 10 nur die Rückwand 12 von der Einsteckseite her dargestellt. Auf die Darstellung des Baugruppenträgergehäuses und der Schiebeführungen für die Steckbaugruppen wurde verzichtet, da diese allgemein bekannt sind.

Den einzelnen Steckplätzen A - E für Steckbaugruppen ist jeweils eine obere und eine untere Buchsenleiste 14, 16 zugeordnet. Alle Steckplätze sind gleich aufgebaut, sie werden deshalb exemplarisch an Hand des Steckplatzes A beschrieben. Zwischen den Buchsenleisten 14, 16 befindet sich ein Durchbruch 18 in der Rückwand 12, durch den eine als erstes Gewindeelement dienende Gewindemutter 20 hindurchragt. Diese ist drehfest mit der Welle eines Elektromotors 22 verbunden, der auf der Rückseite der Rückwand 12 angeordnet ist.

Dem Steckplatz A gegenüberstehend, d.h. teilweise in den Baugruppenträger 10 eingeschoben, ist eine Steckbaugruppe 24 dargestellt, an deren - in Einsteckrichtung gesehen - vorderer Kante 26 mit den Buchsenleisten 14, 16 korrespondierende Messerleisten 28, 30 befestigt sind. Zwischen diesen ist an der Vorderkante 26 der Steckbaugruppe 24 ein zweites Gewindeelement 32 angebracht. Dieses besteht aus einem zylindrischen Teil 34, welcher auf einer Seite zur Befestigung an der Steckbaugruppe 24 abgeplattet ist, und einer Gewindespindel 36, die sich in Einsteckrichtung der Steckbaugruppe 24 erstreckt.

Fig. 2 zeigt die Gewindemutter 20 und die Gewindespindel 36. Die ersten beiden Gewindegänge 38 der Gewindespindel 36 sind abgeflacht und haben eine rundes Profil, während die restlichen Gewindegänge 40 scharf profiliert sind und die volle Gewindetiefe haben. Die Spitze 42 ist angefast, so daß sich ein Einführkonus ergibt, der das lagerichtige Zusammenführen von Spindel 36 und Gewindemutter 20 erleichtert.

Die Gewindemutter 20 hat einen zylindrischen Querschnitt. In ihre Stirnseite 44 ist eine koaxiale Nut 46 eingebracht, so daß sich eine konzentrische Hülse 48 auf einem Teil ihrer Höhe ergibt. Zumindest die Hülse 48 besteht aus einem elastischen Material. Die Gewindemutter 20 einschließlich der Hülse 48 ist von einen Innengewinde 50 durchsetzt. Die Hülse 48 ist kreuzweise parallel zu der Gewindeachse geschlitzt, so daß sich vier konzentrisch um die Gewindeachse angeordnete Federarme 52 ergeben. Selbstverständlich ist auch eine andere Zahl von Schlitzen und damit von Federarmen möglich. Mit ihrem der Stirnseite 44 gegenüberliegenden Ende ist die Gewindemutter 20 mit der Welle 54 des Motors 22 verbunden.

Soll eine Steckbaugruppe 24 in den Baugruppenträger 10 eingerückt werden, so wird diese entlang der Schiebeführungen in den Baugruppenträger 10 so weit eingeschoben, daß die Spitze 42 der Gewindespindel 36 in die Gewindemutter 20 eingeführt wird. Beim weiteren Einschieben drücken die abgeflachten Gewindegänge 38 die Federarme 52 zunächst auseinander, um schließlich mit deren Gewindegängen zu verrasten. Das Verrasten wird noch dadurch erleichtert, daß die Gewindegänge der Gewindemutter 20 in Folge einer kontrollierten Motorsteuerung in einer definierten Winkelstellung zu den Gewindegängen der Gewindespindel stehen. Damit ist immer eine vorbestimmte Einrastposition gegeben, in der der Motor bei ausgerückter Steckbaugruppe 24 stillsteht. Die Messerleisten 28, 30 haben in dieser Stellung noch keinen Kontakt mit den Buchsenleisten 14, 16 des Baugruppenträgers, so daß noch keine Steckkräfte von den Gewindeelementen 20, 36 zu übertragen sind. Die Federkraft der Federarme 52 reicht aber schon aus, um bei Betrieb des Motors 22 in Einzugrichtung die Spindel sicher zu halten. Die Steckbaugruppe 24 wird von dem Motor weiter eingezogen, bis tiefe Gewindegänge 40 der Gewindespindel 36 von der Gewindemutter ergriffen werden. Dadurch können auch die Einsteckkräfte der Buchsen-/Messerleistenanordnung über die Gewindeelemente übertragen werden, ohne daß letztere auseinanderrasten. Dies ist zum einen darauf zurückzuführen, daß die tiefen Gewindegänge 40 scharf profiliert sind, wodurch das die Federarme 52 auseinanderdrängende Kraftmoment verringert wird. Zum anderen müßten die Federarme 52 wegen der größeren Gewindetiefe der tiefen Gewindegänge 40 zum Ausrasten weiter ausgelenkt werden. Dabei stoßen sie aber an die äußere Wand der Nut 46, so daß ihr maximal möglicher Auslenkweg begrenzt ist. Die Steckbaugruppe 24 wird nun vollständig eingerückt. Der Motor 22 kann zeitgesteuert oder abhängig von seinem Drehmoment - letzteres nimmt stark zu, wenn die Steckbaugruppe 24 ihre Endposition im Baugruppenträger 10 erreicht hat - abgeschaltet werden. Es ist auch möglich, den Motor nur eine der Zahl der Gewindegänge der Gewindespindel 36 entsprechende Anzahl von Umdrehungen ausführen zu lassen.

Zum Ausrücken einer Steckbaugruppe wird der Motor in Auswurfrichtung so lange bestromt, bis der elektrische Kontakt zwischen Messer- und Buchsenleisten unterbrochen ist. Eine Nachlaufzeit des Motors 22 sorgt für eine sichere Unterbrechung der elektrischen Verbindung und für den Stillstand der Gewindemutter in der vorbestimmten Einrastposition.

Selbstverständlich ist es auch möglich, die Gewindemutter an der Steckbaugruppe und die Gewindespindel am Motor anzubringen, oder den Motor in der Steckbaugruppe anzuordnen.

## Patentansprüche

1. Vorrichtung zum Einrücken einer Steckbaugruppe (24) in einen Baugruppenträger (10) und zum Ausrücken aus diesem, mit Gewindeelementen (20,36), deren eines an dem Baugruppenträger (10) und deren anderes an der Steckbaugruppe (24) so angebracht ist, daß ihre Gewindeachsen in Steckrichtung der Steckbaugruppe (24) ausgerichtet sind und bei in den Baugruppenträger (10) eingesteckter Steckbaugruppe (24) miteinander fluchten,
**dadurch gekennzeichnet,**
daß die Gewindeelemente als Gewindespindel (36) und Gewindemutter (20) ausgebildet sind, deren eines (20) drehfest mit einem Motor (22) verbunden und durch diesen um seine Gewindeachse drehbar ist, und daß das Gewinde wenigstens eines der Gewindeelemente (20, 36) so gestaltet ist, daß eine Transportverbindung zwischen Gewindespindel (36) und Gewindemutter (20) durch Zusammendrücken beider Gewindeelemente (20, 36) ohne deren Drehung durch Verrasten wenigstens eines ersten Gewindeganges (38) herstellbar ist.

2. Vorrichtung nach Anspruch 1,
**dadurch gekennzeichnet,**
daß das eine Gewindeelement Gewindespindel (36) bzw. Gewindemutter (20) an der Rückwand (12) des Baugruppenträgers (10) so angebracht ist, daß sein Gewinde von der Einsteckseite des Baugruppenträgers (10) aus zugänglich ist, und das andere Gewindeelement Gewindemutter (20) bzw. Gewindespindel (36) an der in Einsteckrichtung vorderen Kante (26) der Steckbaugruppe (24) angeordnet ist.

3. Vorrichtung nach Anspruch 1 oder 2,
**dadurch gekennzeichnet,**
daß zumindest der erste Gewindegang (38) der Gewindemutter (20) an konzentrisch um deren Gewindeachse angeordneten Federarmen (52) ausgebildet ist, wobei deren Federkraft auf die Gewindeachse gerichtet ist.

4. Vorrichtung nach Anspruch 3,
**dadurch gekennzeichnet,**
daß die Gewindemutter (20) eine hohlzylindrische, auf einem Teil ihrer Länge mehrfach, vorzugsweise vierfach geschlitzte Hülse (48) aus einem elastischen Material umfaßt, deren Innenseite das Gewinde (50) trägt.

5. Vorrichtung nach einem der Ansprüche 1 bis 4,
**dadurch gekennzeichnet,**
daß zumindest der erste Gewindegang (38) der Gewindespindel (36) abgeflacht und/oder abgerundet ist.

6. Vorrichtung nach einem der Ansprüche 2 bis 5,
**dadurch gekennzeichnet,**
daß der Motor (22) auf der der Einsteckseite des Baugruppenträgers (10) abgewandten Seite der Rückwand (12) angeordnet ist und das mit ihm verbundene Gewindeelement (20) durch einen Durchbruch (18) in der Rückwand (12) hindurchragt.

7. Vorrichtung nach einem der Ansprüche 1 bis 6,
**dadurch gekennzeichnet,**
daß der Motor (22) durch eine den Baugruppenträger (10) umfassende Anlage steuerbar ist.

## Claims

1. Apparatus for pushing a plug-in assembly (24) into a mounting rack (10) and for pushing it out of said mounting rack (10), having threaded elements (20, 36), one of which is fitted to the mounting rack (10) and the other of which is fitted to the plug-in assembly (24) such that their thread axes are aligned in the insertion direction of the plug-in assembly (24) and are flush with one another when the plug-in assembly (24) is inserted in the mounting rack (10),
characterized
in that the threaded elements are designed as a threaded rod (36) and a threaded nut (20), one of which (20) is connected in a rotationally fixed manner to a motor (22) and can be rotated by this motor (22) about its thread axis, and in that the thread of at least one of the threaded elements (20, 36) is designed such that a transport connection can be produced between the threaded rod (36) and the threaded nut (20) by pressing the two threaded elements (20, 36) together, without rotating them, by latching of at least a first thread pitch (38).

2. Apparatus according to Claim 1,
characterized
in that one threaded element, threaded rod (36) or threaded nut (20) is fitted to the back plane (12) of the mounting rack (10) such that its thread is accessible from the insertion side of the mounting rack (10), and the other threaded element, threaded nut (20) or threaded rod (36) is arranged on the front edge (26), in the insertion direction, of the plug-in assembly (24).

3. Apparatus according to Claim 1 or 2,
characterized
in that at least the first thread pitch (38) of the threaded nut (20) is constructed on spring arms (52) which are arranged concentrically around its thread axis, the spring force of which spring arms (52) is directed onto the thread axis.

4. Apparatus according to Claim 3,
characterized
in that the threaded nut (20) comprises a hollow-cylindrical sleeve (48) which is slotted a plurality of times over part of its length, preferably four times, is composed of elastic material and whose inside has the thread (50).

5. Apparatus according to one of Claims 1 to 4,
characterized
in that at least the first thread pitch (38) of the threaded rod (36) is flattened and/or rounded.

6. Apparatus according to one of Claims 2 to 5,
characterized
in that the motor (22) is arranged on the side of the back plane (12) facing away from the insertion side of the mounting rack (10), and the threaded element (20) which is connected to it projects through an aperture (18) in the back plane (12).

7. Apparatus according to one of Claims 1 to 6,
characterized
in that the motor (22) can be controlled by a system which surrounds the mounting rack (10).

## Revendications

1. Dispositif pour enfoncer un module (24) enfichable dans un porte-module (10) et pour l'en retirer, comportant un élément (20) taraudé et un élément (36) fileté, dont l'un est monté sur le porte-module (10) et dont l'autre est monté sur le module (24) enfichable de telle manière, que l'axe de taraudage de l'un et l'axe de filetage de l'autre sont dirigés dans la direction d'enfichage du module (24) enfichable et sont en alignement l'un avec l'autre lorsque le module (24) enfichable est enfiché dans le porte-module (10),
caractérisé en ce que les éléments taraudé et fileté sont réalisés en broche (36) filetée et en écrou (20) taraudé, dont l'un (20) est relié de manière solidaire en rotation à un moteur (22) et peut tourner par rapport à son axe de taraudage par ce moteur, et en ce que le filetage ou le taraudage d'au moins l'un des éléments (20,36) taraudé ou fileté est conformé de telle manière, qu'une liaison de transport entre la broche (36) filetée et l'écrou (20) taraudé peut être produite en serrant les deux éléments (20,36) taraudé et fileté sans les faire tourner, par encliquetage d'au moins un premier pas (38) de filetage.

2. Dispositif suivant la revendication 1,
caractérisé en ce qu'un élément fileté ou taraudé, broche (36) filetée ou écrou (20) taraudé, est monté sur la paroi (12) arrière du porte-module (10) de telle manière que son filetage ou son taraudage est accessible du côté d'enfichage du porte-module (10) et en ce que l'autre élément taraudé ou fileté, écrou (20) taraudé ou broche (36) filetée, est monté sur le bord (26) avant dans le sens d'enfichage du module (24) d'enfichage.

3. Dispositif suivant la revendication 1 ou 2,
caractérisé en ce qu'au moins le premier pas (38) de taraudage de l'écrou (20) taraudé est réalisée sur des bras (52) élastiques disposés concentriquement par rapport à son axe de taraudage, leur force élastique étant dirigée vers l'axe de taraudage.

4. Dispositif suivant la revendication 3, caractérisé en ce que l'écrou (20) taraudé comporte une douille (48) en matériau élastique cylindrique creuse, qui est fendue plusieurs fois, de préférence quatre fois, sur une partie de sa longueur et dont la face intérieure porte le taraudage (50).

5. Dispositif suivant l'une des revendications 1 à 4, caractérisé en ce qu'au moins le premier pas (38) de filetage de la broche (36) filetée est aplati et/ou arrondi.

6. Dispositif suivant l'une des revendications 2 à 5, caractérisé en ce que le moteur (22) est monté du côté de la paroi (12) arrière éloignée du côté d'enfichage du porte-module (10), et en ce que l'élément (20) taraudé qui lui est relié passe dans un passage (18) ménagé dans la paroi (12) arrière.

7. Dispositif suivant l'une des revendications 1 à 6, caractérisé en ce que le moteur (22) peut être commandé par une installation comprenant le porte-module (10).
